# EUROPEAN PATENT APPLICATION

(11) **EP 1 187 188 A1**
(43) Date of publication of application: **13.03.2002**
(21) Application number: 01902832.3
(22) Date of filing: 09.02.2001
(51) Int. Cl.: H01L 21/31, H01L 21/205, H01L 21/302

(54) **METHOD OF PROCESSING WAFER**

(30) Priority: 18.02.2000 JP 2000041021
(71) Applicant: TOKYO ELECTRON LIMITED, Minato-ku, Tokyo 107-8481 (JP)
(72) Inventor: SUZUKI, Fujio, Tokyo Electron Tohoku Limited, Tsukui-gun, Kanagawa 220-0101 (JP); SAKAMOTO, Koichi, Tokyo Electron Tohoku Limited, Tsukui-gun, Kanagawa 220-0101 (JP); WANG, Wenling, c/o Tokyo Electron Tohoku Limited, Tsukui-gun, Kanagawa 220-0101 (JP); YASUHARA, Moyuru, c/o Tokyo Electron Limited, Tokyo 107-8481 (JP)
(74) Representative: Liesegang, Eva
(86) International application number: JP0100941
(87) International publication number: WO0161736

(57) **Abstract**

A plurality of wafers W are mounted on a wafer boat 11 in a reaction tube 1 having a double-tube structure as shelves, and zones 6a, 6b and 6c in the reaction tube 1 are heated to a first process temperature, e.g., 770°C, by heating parts 4a, 4b and 4c of a heater 4, respectively. Then, while the temperature in each of the zones 6a, 6b and 6c is lowered to a second process temperature, e.g., 750°C, which is lower than the first process temperature, a deposition gas is fed to deposit a thin film. If a step of raising the temperature in each of the zones 6a, 6b and 6c and a step of feeding the deposition gas while lowering the temperature of each of the zones 6a, 6b and 6c are repeatedly carried out, a deposition process is carried out while the temperature of the peripheral edge portion of each of the wafers W is lower than the temperature of the central portion of the wafer W. Thus the uniformity of the thickness of the film deposited on each of the wafers is improved. If the temperature dropping rate in each of the zones 6a, 6b and 6c is separately set for each of the zones, it is possible to achieve the optimum deposition process in each of the zones.

## Description

### TECHNICAL FIELD

The present invention relates generally to a substrate processing method for processing a substrate, such as a semiconductor wafer.

### BACKGROUND ART

As one of deposition processes for producing semiconductor devices, there is a process called the chemical vapor deposition (CVD). This technique is designed to feed a process gas into a reaction tube to deposit a thin film on the surface of a semiconductor wafer (which will be hereinafter referred to as a "wafer") by a chemical gas phase reaction. As one of systems for carrying out such a deposition process as a batch process, there is a vertical heat treating system. This system comprises a vertical reaction tube provided above a tubular manifold, a heater provided so as to surround the reaction tube, a gas feed tube inserted into the manifold, and an exhaust tube connected to the manifold. In such a system, a plurality of wafers are held on a holder called a wafer boat as shelves to be carried in the reaction tube from an opening, which is formed in the bottom end of the manifold, to carry out a deposition process.

Specifically, for example, when a silicon nitride film serving as an interlayer dielectric film is intended to be deposited, the wafers are heated to a process temperature, e.g., 760°C, in a vacuum atmosphere of about 1 Torr. Then, while this heating atmosphere is maintained, ammonia (NH₃) gas and dichlorosilane (SiH₂,Cl₂,) gas serving as deposition gases are fed to deposit the film.

By the way, if the film is deposited on the wafer on the above described conditions using the above described system, the thickness of the film on the central portion of the wafer tends to be smaller than that on the peripheral edge portion of the wafer. It is considered that the reason for this is as follows. That is, in the above described vertical heat treating system called a batch furnace, the wafer is heated by the heater, which is arranged around the periphery of the wafer, in the process for raising the temperature of the wafer to the process temperature. Therefore, since the endothermic quantity per unit area on the peripheral edge portion of the wafer is larger than that on the central portion of the wafer, the temperature rising rate on the peripheral edge portion is higher than that on the central portion, so that the temperature of the peripheral edge portion is higher than the temperature of the central portion. Also, in the above described system, the deposition gas is fed into the reaction tube via the gas feed tube to be supplied to the wafer, which is held on the wafer boat, from the peripheral edge side of the wafer, so that the concentration of the deposition gas on the peripheral edge portion of the wafer is higher than that on the central portion.

It is thus guessed that a deposition reaction on the peripheral edge portion of the wafer, on which the temperature and deposition gas concentration are higher, proceeds at higher rate than that on the central portion of the wafer due to the temperature difference and concentration difference of the deposition gas caused between the peripheral edge portion and the central portion of the wafer, so that the thickness of the film on the central portion of the wafer is smaller than that on the peripheral edge portion thereof to deteriorate the inplane uniformity of the thickness. Therefore, there is a problem in that such inplane uniformity of thickness is more deteriorated when a large-diameter wafer, such as a wafer of 300 mm is processed, or a thick film having a thickness of 70 nm or more is formed on the wafer.

### DISCLOSURE OF THE INVENTION

The present invention has been made in such circumstances, and it is an object of the present invention to provide a deposition method capable of ensuring a high inplane uniformity of thickness when a film is deposited on a substrate.

According to one aspect of the present invention, there is provided a substrate processing method for processing a substrate by arranging the substrate in each of a plurality of zones in a reaction vessel and feeding a process gas into the reaction vessel, the substrate processing method comprising: a temperature rising step of heating each of the zones in the reaction vessel by a heating unit to raise the temperature in each of the zones to a first process temperature for a corresponding one of the zones; and a temperature transition step of transferring the temperature in each of the zones in the reaction vessel from the first process temperature for the corresponding one of the zones to a second process temperature for the corresponding one of the zones, wherein a process gas is fed into the reaction vessel in the temperature transition step to process the substrate.

In this substrate processing method the first process temperature for the corresponding one of the zones may be different from that for another one of the zones.

In the substrate processing method, the second process temperature for the corresponding one of the zones may be different from that for another one of the zone.

In the substrate processing method, the temperature in each of the zones may be lowered, raised or held from the first process temperature to the second process temperature at the temperature transition step.

In the substrate processing method, the temperature in each of the zones may be lowered or raised from the first process temperature to the second process temperature in the temperature transition step.

In the substrate processing method, each of the zones in the reaction vessel is heated in the temperature rising step by a heating part of the heating unit which may be provided outside the corresponding one of the zones.

In the substrate processing method, the feeding of the process gas into the reaction vessel may be stopped at the temperature rising step.

In the substrate processing method, each of the zones may be heated to the first process temperature of 770°C in the temperature rising step, and the temperature in each of the zones may be lowered from the first process temperature of 770 °C to the second process temperature of 750 °C in the temperature transition step.

In the substrate processing method, the heating of one of the zones by the heating part corresponding to the one of the zones may be suppressed to lower the temperature in the one of the zones in the temperature transition step.

In the substrate processing method, a deposition gas may be fed from a gas feed tube provided in the peripheral portion of the reaction vessel, in the temperature transition step.

The substrate processing method may further comprise an additional temperature transition step for changing the temperature in each of the zones from the second process temperature to the first process temperature.

In the substrate processing method, the temperature transition step and the additional temperature transition step are repeatedly carried out.

According to another aspect of the present invention, there is provided a substrate processing method for processing a substrate by arranging the substrate in each of a plurality of zones in a reaction vessel and feeding a process gas into the reaction vessel, the substrate processing method comprising: a temperature rising step of heating each of the zones in the reaction vessel by a heating unit to raise the temperature in each of the zones to a first process temperature for a corresponding one of the zones; and a temperature changing step of changing the temperature in each of the zones in the reaction vessel from the first process temperature for the corresponding one of the zones to a second process temperature for the corresponding one of the zones, wherein a process gas is fed into the reaction vessel in the temperature changing step to process the substrate.

In this substrate processing method, the first process temperature for the corresponding one of the zones may be different from that for another one of the zones.

In the substrate processing method, the second process temperature for the corresponding one of the zones may be different from that for another one of the zone.

In the substrate processing method, the temperature in at least one of the zones may be lowered from the first process temperature to the second process temperature in the temperature changing step.

In the substrate processing method, the temperature in at least one of the zones may be raised from the first process temperature to the second process temperature in the temperature changing step.

In the substrate processing method, each of the zones in the reaction vessel may be heated at the temperature rising step by a heating part of the heating unit which is provided outside the corresponding one of the zones.

In the substrate processing method, the feeding of the process gas into the reaction vessel may be stopped at the temperature rising step.

In the substrate processing method, the heating of one of the zones by the heating part corresponding to the one of the zones may be suppressed to lower the temperature in the one of the zones in the temperature changing step.

### BRIEF DESCRIPTION OF THE DRAWINGS

FIG. 1 is a longitudinal section showing an example of a vertical heat treating system for carrying out a substrate processing method according to the present invention;
FIG. 2 is a perspective view showing a part of the vertical heat treating system;
FIG. 3 is a characteristic diagram showing the relationship between temperature and time when a silicon nitride film is formed by a substrate processing method according to the present invention;
FIG. 4 is a characteristic diagram showing the relationship between temperature and time when a silicon nitride film is deposited;
FIG. 5 is a characteristic diagram showing the relationship between the thickness of a silicon nitride film and its position on a water;
FIG. 6 is a characteristic diagram showing the relationship between temperature and the position on a wafer;
FIG. 7 is a characteristic diagram showing the relationship between the thickness of a silicon nitride film and the position on a wafer;
FIG. 8 is a characteristic diagram showing the relationship between the inplane dispersion degree of the thickness of a silicon nitride film and the position of a wafer on a wafer boat;
FIG. 9 is a characteristic diagram showing the relationship between the thickness of a silicon nitride film and its position on a wafer;
FIG. 10 is a plan view for explaining sampling places on a wafer;
FIG. 11 is a characteristic diagram showing the relationship between temperature and time when a silicon nitride film is deposited; and
FIG. 12 is a characteristic diagram showing the relationship between temperature and time when a silicon oxide film is deposited.

### BEST MODE FOR CARRYING OUT THE INVENTION

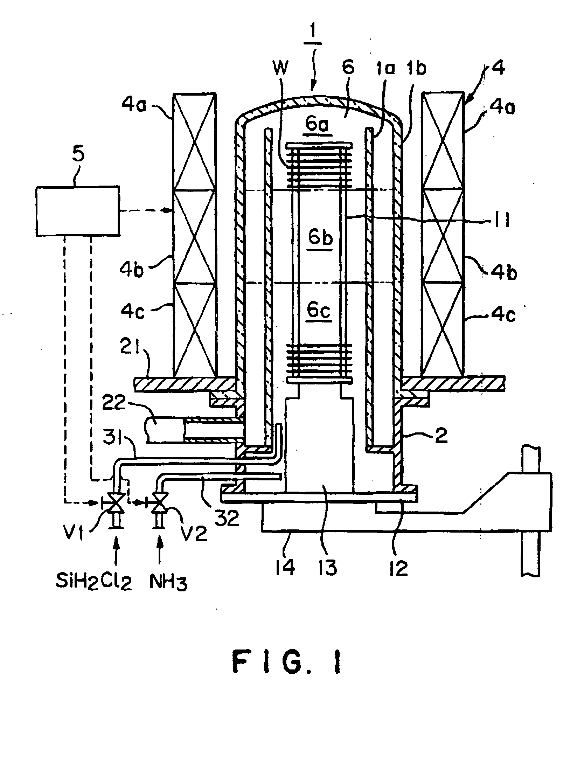

First, referring to FIG. 1, an example of a vertical heat treating system for carrying out a substrate processing method according to the present invention will be described below. In FIG. 1, reference numeral 1 denotes a reaction tube having a double-tube structure comprising an inner tube 1a and an outer tube 1b, which are made of, for example quartz. On the side of the lower portion of the reaction tube (reaction vessel) 1, a tubular metal manifold 2 is provided.

The top end of the inner tube 1a is open, and is supported on the inside of the manifold 2. The top end of the outer tube 1b is closed, and the bottom end thereof is airtightly connected to the top end of the manifold 2. In this example, the inner tube 1a, the outer tube 1b and the manifold 2 constitute a processing chamber 6. Reference numeral 21 denotes a base plate.

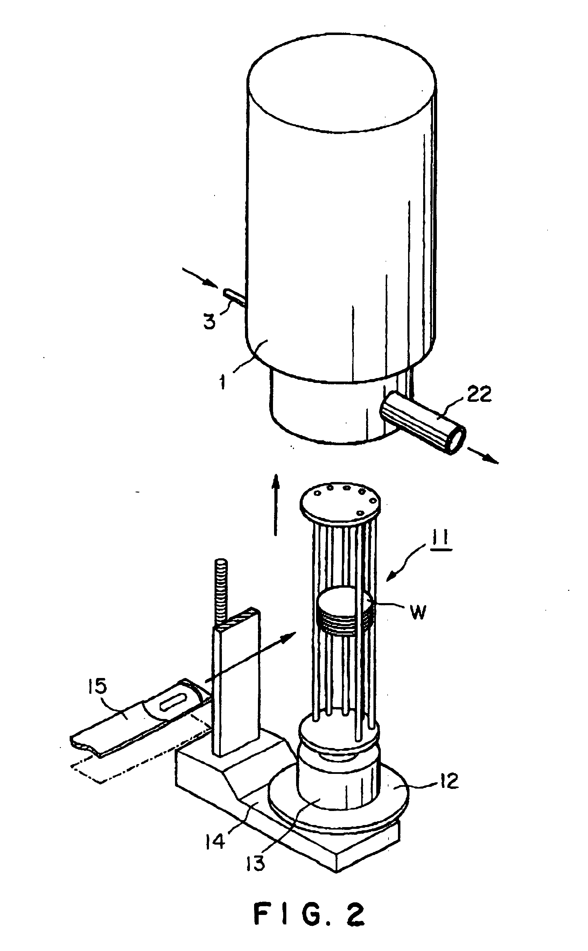

For example, as shown in FIG. 2, in the reaction tube 1, a plurality of (for example, about 170) wafers W serving as substrates are horizontally supported on a wafer boat 11 serving as a holder, and are vertically spaced from each other at intervals. The wafer boat 11 is supported on the top of a lid 12 via a heat reserving cylinder (heat insulating body) 13. The lid 12 is mounted on the surface of a boat elevator 14 for carrying the wafer boat 11 in and out of the reaction tube 1, and serves to close a bottom end opening of the manifold 2, i.e., a bottom end opening of the processing chamber formed by the reaction tube 1 and manifold 2, when the lid 12 is positioned at the upper limit position. In FIG. 2, reference numeral 15 denotes a transfer arm for transferring the wafers W to the wafer boat 11.

The manifold 2 is circumferentially provided with a plurality of gas feed tubes 31 and 32 for feeding deposition gases (process gas) and a purge gas to the inside of the inner tube 1a so that the deposition gases are fed into the processing chamber 6 from the gas feed tubes 31 and 32. Each of the gas feed tubes 31 and 32 is made of quarts. For example, the gas feed tube 31 is formed by inserting a quarts tube into the manifold 2 from the outside and by bending the tip portion of the quarts tube upwards, and the gas feed tube 32 is formed by inserting a quarts tube into the manifold 2 from the outside. One or more of the gas feed tubes 31 and 32 function as a tube for feeding nitrogen gas (N₂, gas) serving as a purge gas and a tube for feeding a deposition gas. In addition to the deposition gases, oxygen gas may be fed into the inner tube 1a as a process gas.

The gas feed tubes 31 and 32 are connected to gas sources (not shown) for deposition gases of, for example, SiH₂,Cl₂, gas and NH₃ gas, via shut-off valves V₁ and V₂, respectively. The timings in opening and closing the shut-off valves V₁ and V₂ are controlled by a control unit 5 on the basis of a previously inputted deposition gas feeding program during deposition, so that the timings in feeding the deposition gases are controlled. The exhaust tube 22 is connected to the manifold 2 to open to a space between the inner tube 1a and the outer tube 1b, so that the interior of the processing chamber is evacuated by a vacuum pump (not shown).

A heater (heating unit) 4 is provided so as to surround the periphery of the reaction tube 1. For example, the heater 4 comprises a heating resistor, the temperature of which is controlled by the control unit 5 on the basis of a previously inputted temperature profile for a deposition process. The processing chamber 6 in the reaction tube 1 is divided into a plurality of, for example, three, zones 6a, 6b and 6c from top to bottom. The heater 4 comprises three heating parts 4a, 4b and 4c which are arranged so as to correspond to the zones 6a, 6b and 6c, respectively.

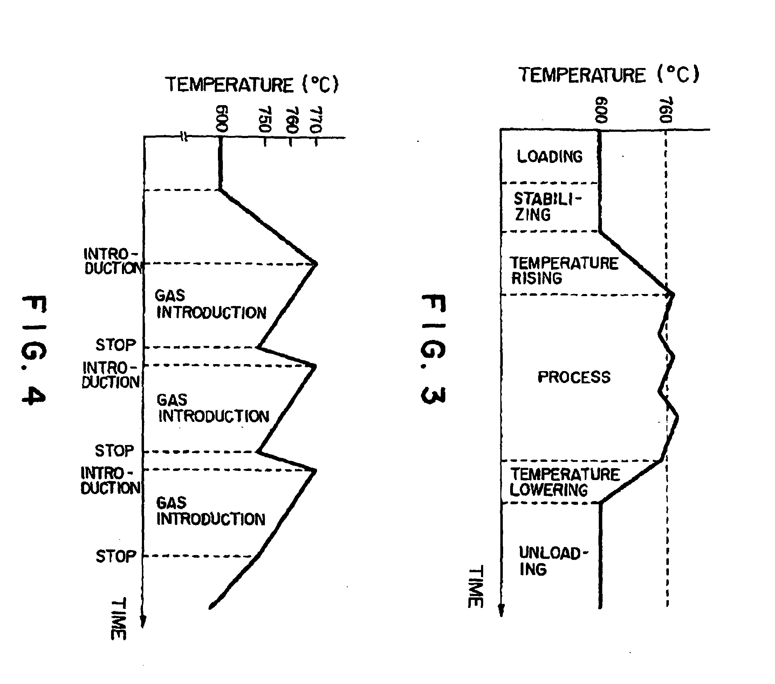

As an example of a substrate processing method according to the present invention which is carried out by the above described system, a method for depositing a silicon nitride film will be described referring to FIG. 3. First, a plurality of, for example, 170, wafers (objects to be processed) W are mounted on the wafer boat 11. Then, the boat elevator 14 is moved upwards to carry the wafers W into the reaction tube 1 via the bottom end opening, which is maintained in a heated atmosphere of, for example 600°C. Then, the bottom end opening of the manifold 2, i.e., the wafer carrying-in/out port of the processing chamber 6, is airtightly closed by the lid 12 (loading step). Then, the processing chamber in a heated atmosphere of, for example, 600°C, is evacuated through the exhaust tube 22 by means of a vacuum pump (not shown) (stabilizing step).

Subsequently, the zones 6a, 6b and 6c in the reaction tube 1 are heated to a first process temperature, for example a temperature of about 770°C, by means of the heating parts 4a, 4b and 4c, respectively (temperature rising step). Thereafter, while the temperature is controlled on the basis of the predetermined temperature profile, SiH₂,Cl₂, gas and NH₃, gas serving as deposition gases are fed into the inner tube 1a via the gas feed tubes 31 and 32, respectively, to form a silicon nitride film on the surface of each of the wafers while the pressure in the reaction tube 1 is kept at 0.25 Torr (process step). At this time, the deposition gas are fed into the inner tube 1a and the outer tube 1b is exhausted by the exhaust tube 22, so that the deposition gases can spread in the whole of the reaction tube 1 to uniformly form the silicon nitride film on the surface of each of the wafers which are mounted on the wafer boat 11.

Although the same temperature control is carried out with respect to the zones 6a, 6b and 6c, different temperature controls may be carried out as will be described later.

The present invention is characterized in that the temperature control of the wafers W is carried out at the process step and the deposition gases are intermittently fed in accordance with the temperature control. For example, in the process step, the temperature of each of the zones 6a, 6b and 6c is controlled so as to repeatedly rise and fall in a range of from the first process temperature to a second process temperature which is lower than the first process temperature, specifically around 760°C, for example, in a range of from 750 °C to 770 °C. when the temperature falls (is lowered), the deposition gases are fed.

In an example of a concrete process, as shown in FIG. 4, after the respective zones 6a, 6b and 6c are heated by the heating parts 4a, 4b and 4c to about 770°C, which is the first process temperature, in the temperature rising step, the heating temperature of the heating parts 4a, 4b and 4c is suppressed so that the first temperature fall to the second process temperature which is lower than the first process temperature, for example, about 750°C, in, for example, about 23 minutes. Simultaneously with the starting of the temperature fall, SiH₂Cl₂ gas and NH₃ gas are fed in the flow rates of 100 sccm and 1000 seem, respectively (temperature transition step or temperature changing step). Then, while the feeding of these deposition gases is stopped, the temperature of each of the zones 6a, 6b and 6c is raised to about 770 °C in, for example about 4 minutes (additional temperature transition step or additional temperature changing step). Then, while the deposition gases are fed, the temperature of each of the zones 6a, 6b and 6c is lowered to about 750°C in, for example about 23 minutes (temperature transition step or temperature changing step). Subsequently, while the feeding of the deposition gases is stopped, the temperature of each of the zones 6a, 6b and 6c is raised again to about 770°C in, for example about 4 minutes (additional temperature transition step). Then, while the deposition gases are fed, the temperature of each of the zones 6a, 6b and 6c is lowered again to about 750°C in, e.g., 23 minutes. That is, in these steps, the feeding of the deposition gases is started simultaneously with the temperature start to fall, and the feeding of the deposition gases is stopped simultaneously with the temperature start to rise (the termination of temperature drop).

In this preferred embodiment, the zones 6a, 6b and 6c are heated by the heating parts 4a, 4b and 4c of the heater 4, respectively. As described above, the predetermined temperature control at the process step is carried out by controlling the heating temperature of the heater 4 by means of the control unit 5 on the basis of the temperature profile which has been inputted into the control unit 5. The feeding of the deposition gases is started and stopped by opening and closing the shut-off valves V. The opening and closing of the shut-off valves V is controlled by the control unit 5 as described above.

After the deposition of predetermined silicon nitride films is thus completed, the feeding of the deposition gases is stopped, and the temperature of each of the zones 6a, 6b and 6c is lowered to about 600°C. In addition, a purge gas, for example N₂ gas, is fed from, for example two tubes, of the gas feed tubes 31 and 32 which have been used for feeding the deposition gases during the deposition process, to return the pressure in the processing chamber 6 to normal pressure. Then, the boat elevator 14 is moved downwards, and the carrying-in/out port provided in the bottom end of the processing chamber is open. As a result, the wafer boat 11 is taken out from the processing chamber (unloading step).

Thus, according to this preferred embodiment, the surface temperature of the wafers W is controlled in the process step so as to repeat temperature rise and temperature fall, and the deposition gases are fed when the temperature falls, so that it is possible to enhance the uniformity of the thickness of the formed silicon nitride film.

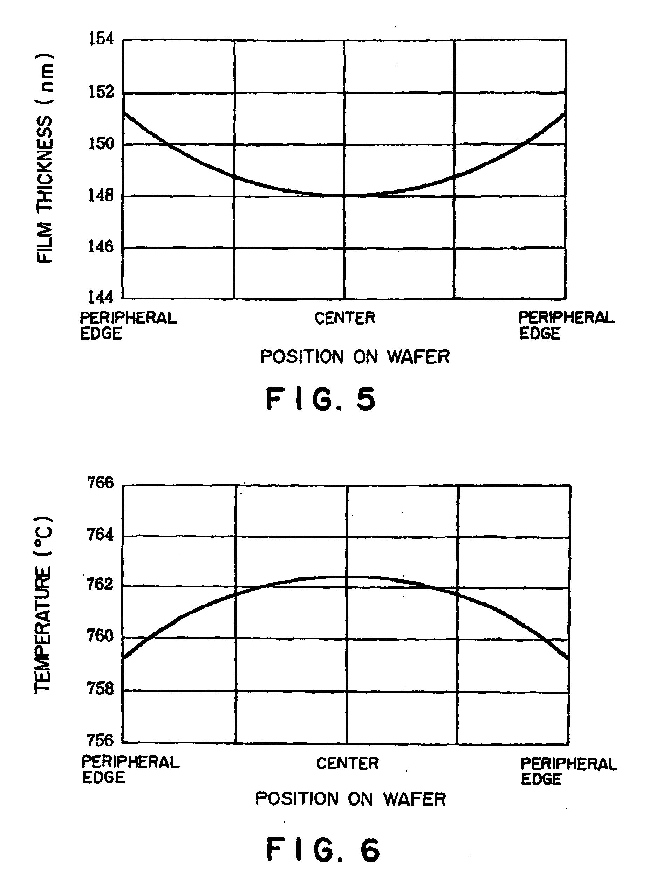

That is, as described above, since the endothermic quantity per unit area on the peripheral edge portion of the wafer W is larger than that on the central portion of the wafer W when the temperature of the wafer W rises, the temperature of the peripheral edge portion is higher than the temperature of the central portion. The growth rate of the film is higher, as the temperature during the deposition process is higher. Therefore, if the deposition gases are fed to deposit the film immediately after the temperature of each of the zones 6a, 6b and 6c rises to a predetermined temperature, the thickness of the film on the central portion of the wafer is smaller than that on the peripheral edge portion of the wafer as shown in FIG. 5, due to the above described concentration distribution of the deposition gas on the surface of the wafer. FIG. 5 is a characteristic diagram showing a thickness distribution of a silicon nitride film formed on a wafer when the silicon nitride film is deposited by feeding deposition gases immediately after the temperature of each of the zones 6a, 6b and 6c is raised to, for example, 760 °C and maintaining the temperature.

On the other hand, since the radiation quantity per unit area on the peripheral edge portion of the wafer W is larger than that on the central portion of the wafer W when the temperature of the wafer W falls, the temperature falling rate on the peripheral edge portion is higher than that on the central portion, so that the temperature of the peripheral edge portion is lower than the temperature of the central portion as shown in FIG. 6 (the temperature distribution on the surface of the wafer when the temperature of each of the zones 6a, 6b and 6c is lowered from about 770°C to about 750°C).

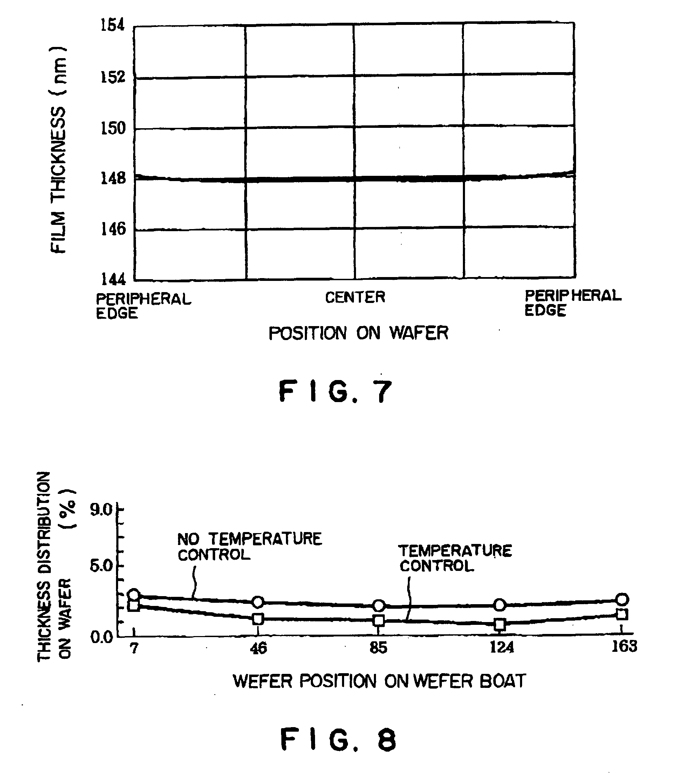

Therefore, it is expected that the thickness of the deposited film will be substantially uniform on the surface of the wafer W as shown in FIG. 7, under the influence of the temperature distribution of the wafer in the temperature falling step, in which the temperature of the peripheral edge portion of the wafer is lower than that of the central portion of the wafer, and the concentration distribution of the deposition gas, in which the concentration of the deposition gas on the peripheral portion of the wafer is higher than that on the central portion of the wafer, if the temperature of each of the zones 6a, 6b and 6c is lowered to the second process temperature after being raised to the first process temperature and the deposition gases are fed when the temperature falls. FIG. 7 is a characteristic diagram showing a thickness distribution of a silicon nitride film formed on the wafer when the silicon nitride film is deposited by feeding deposition gases when the temperature of each of the zones 6a, 6b and 6c is lowered to the second process temperature after being raised to the first process temperature.

As described above, in this preferred embodiment, when the silicon nitride film is formed, the first process temperature is set to be 770°C, and the second process temperature is set to be 750°C, so that the difference between these temperatures is set to be 20 °C. Although there is a limit to the deposition temperature range since the deposition temperature has an influence on the quality of the silicon nitride film, there is no problem if the difference between the first process temperature and the second process temperature is set to be about 40°C or less.

Therefore, it is desired that the temperature transition step and the additional temperature transition step are repeatedly carried out within a predetermined deposition temperature range in which there is no problem. If the film is thus deposited, it is possible to obtain a good inplane thickness distribution while maintaining required film-quality characteristics. For that reason, the present invention is particularly effective in the deposition of a film on a wafer having a diameter of, e.g., 300 mm or the deposition of a film having a thickness of 70 nm or more. Also in these cases, it is possible to ensure the high inplane uniformity of thickness.

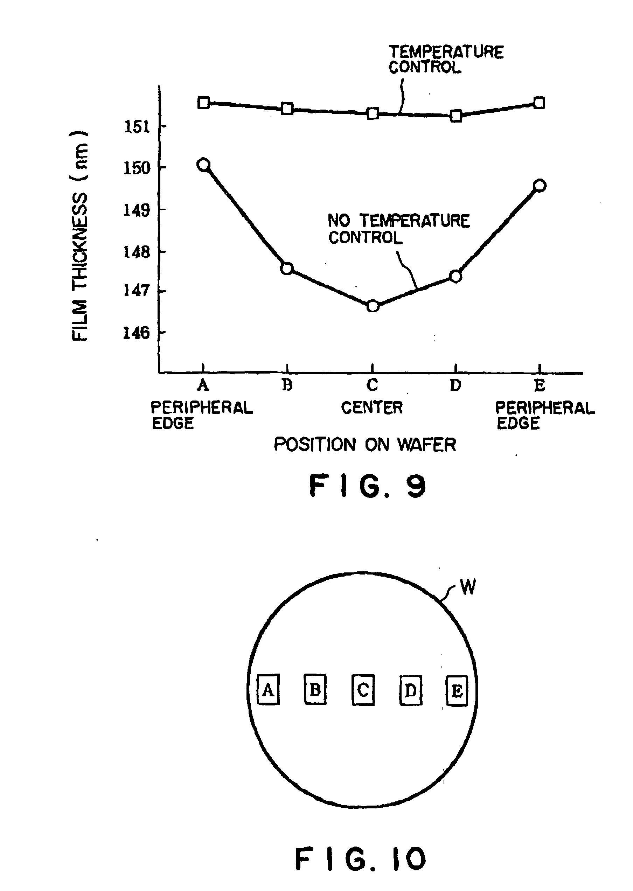

In order to actually confirm the advantages of the present invention, 170 wafers W having a size of 8 inches were mounted on the wafer boat 11, and a silicon nitride film was formed by the above described vertical heat treating system in accordance with the above described process. As a result, the results shown in FIGS. 8 and 9 were obtained. As deposition gases, SiH₂Cl₂, gas and NH₃ gas were used. While the temperature of each of the zones 6a, 6b and 6c is raised and lowered in accordance with the temperature profile shown in FIG. 4 to control the temperature of each of the zones 6a, 6b and 6c, SiH₂Cl₂ gas and NH₃ gas were fed in the flow rates of 100 sccm and 1000 sccm, respectively, when the temperature falls, to form a silicon nitride film having a target thickness of 150 nm under a process pressure of 0.25 Torr. Then, the inplane distribution of the thickness of the silicon nitride film and the inplane uniformity of the thickness of the silicon nitride film were measured. The same experiment was carried out when the silicon nitride was formed by continuously feeding the deposition gases while the surface temperature of the wafer was maintained at 760°C in the above described vertical heat treating system. In this case, the flow rates of SiH₂Cl₂, gas and NH₃ gas were set to be 100 sccm and 1000 seem, respectively, and the process pressure was set to be 0.25 Torr.

These results are shown in FIGS. 8 and 9, respectively. The dispersion degree of the thickness of the silicon nitride film is shown in FIG. 8, and the inplane distribution of the thickness of the silicon nitride film is shown in FIG. 9. In FIGS. 8 and 9,□ denotes a case where the temperature control was carried out according to the present invention, and ○ denotes a case where the temperature control was not carried out. With respect to the dispersion degree of the thickness of the silicon nitride film shown in FIG. 8, the seventh, forty-sixth, eighty-fifth, one-hundred-twenty-fourth, one-hundred-sixty-third wafers W from the top of the wafer boat 11 were sampled, and the inplane uniformity of the thickness of the silicon nitride film formed on each of the sampled wafers W was measure by a thickness measuring equipment (ellipsometer).

As a result, when the temperature control was carried out according to the present invention, the dispersion degree of the thickness was lower than that when the temperature control was not carried out. This dispersion degree shows that the inplane uniformity becomes higher. Therefore, it was confirmed that it was possible to enhance the inplane uniformity of the thickness of the formed silicon nitride film by carrying out the temperature control in the process step according to the present invention and feeding the deposition gases while the surface temperature of the wafer W drops.

With respect to the inplane distribution of the thickness of the silicon nitride film shown in FIG. 9, the one-hundred-twenty-fourth wafer W from the top of the wafer boat 11 was sampled, and the thickness of the silicon nitride film was measured at five positions (A, B, C, D, E) in radial directions on the diameter of the wafer W as shown in the plan view of the wafer W of FIG. 10. In this figure, C denotes the center of the wafer w, A and E denote positions inwardly spaced from the outer edge of the wafer W by 5 mm, and B and C denote positions inwardly spaced from the outer edge of the wafer W by 52.5 mm.

As a result, when the temperature control was not carried out, the thickness of the silicon nitride film on the central portion was smaller than that on the peripheral edge portion by about 2.91 to 3.48 nm, whereas when the temperature control was carried out according to the present invention, the thickness of the silicon nitride film was substantially constant although there was a dispersion of about 0.36 nm. Therefore, it was confirmed that it was possible to enhance the inplane uniformity of the thickness of the formed silicon nitride film by carrying out the temperature control in the process step according to the present invention and feeding the deposition gases during the temperature fall.

In the foregoing, according to the present invention, it is enough to carry out the temperature rising step of raising the temperature of each of the zones 6a, 6b and 6c to the first process temperature, and then, to carry out the temperature transition step of depositing the film by feeding the deposition gases while lowering the temperature of each of the zones 6a, 6b and 6c to the second process temperature for accomplishing the inplane uniformity of the thickness of the silicon nitride film. Thus, it is not always required to repeatedly carry out the temperature transition steps and the additional temperature transition steps. However, if the temperature transition steps and the additional temperature transition steps are repeatedly carried out, it is possible to ensure the higher uniformity of thickness.

Moreover, the present invention can be applied to the deposition of polysilicon films, silicon oxide films based on TEOS, high temperature oxide (HTO) films or the like, in addition to the deposition of silicon oxide films. The present invention can also be applied to the deposition of oxide films based on the dry oxidation, wet oxidation and HCl oxidation in addition to the CVD deposition process.

As described above, according to the present invention, it is possible to ensure the high inplane uniformity of thickness when films are deposited on substrates.

while the same temperature control has been carried out with respect to the zones 6a, 6b and 6c in the reaction tube in the above described preferred embodiment, different temperature controls may be carried out with respect to the zones 6a, 6b and 6c by means of the heating parts 4a, 4b and 4c of the heating unit 4, respectively.

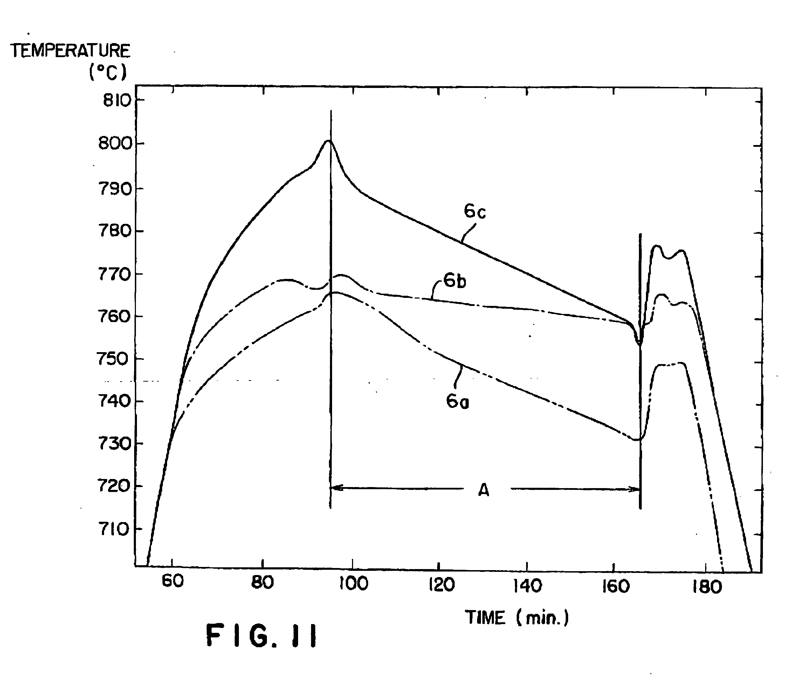

FIG. 11 shows the relationship between time and temperature in each of the zones 6a, 6b and 6c when a silicon nitride film is deposited on the surface of a wafer W using SiH₂Cl₂ gas and NH₃ gas as deposition gases.

As shown in FIG. 11, the respective zones 6a, 6b and 6c have different first process temperatures and different second process temperatures. For example, in the upper zone 6a, the first process temperature is 765 °C, and the second process temperature is 732°C. In the central zone 6b, the first process temperature is 770°C, and the second process temperature is 757°C. In the lower zone 6c, the first process temperature is 800°C, and the second process temperature is 757 °C.

In all of the zones 6a, 6b and 6c, the temperature is first raised to the first process temperature (temperature rising step), and thereafter, the temperature is lowered to the second process temperature in the temperature transition step (A) at which the deposition gases are fed (temperature transition step or temperature changing step). In the temperature transition step or the temperature changing step, the temperatures of all of the zones 6a, 6b and 6c are lowered, and the deposition gases are fed when the temperature falls, so that a uniform silicon nitride film is formed on the surface of the wafer W. In this case, the temperature may be subsequently raised from the second process temperature to the first process temperature (additional temperature transition step), and thereafter, the temperature may be lowered from the first process temperature to the second process temperature (temperature transition step).

If different temperature controls are thus carried out in the respective zones 6a, 6b and 6c, a hot gas is easily fed upwardly into the upper zone 6a. For such a reason, for example, by keeping the temperature of the upper zone 6a at relatively low temperatures and the temperature of the lower zone 6c at relatively high temperatures, it is possible to achieve the uniformity of the silicon nitride film deposited on the surface of the wafer W among the respective zones 6a, 6b and 6c, in addition to the uniformity of the silicon nitride film on the respective wafers w.

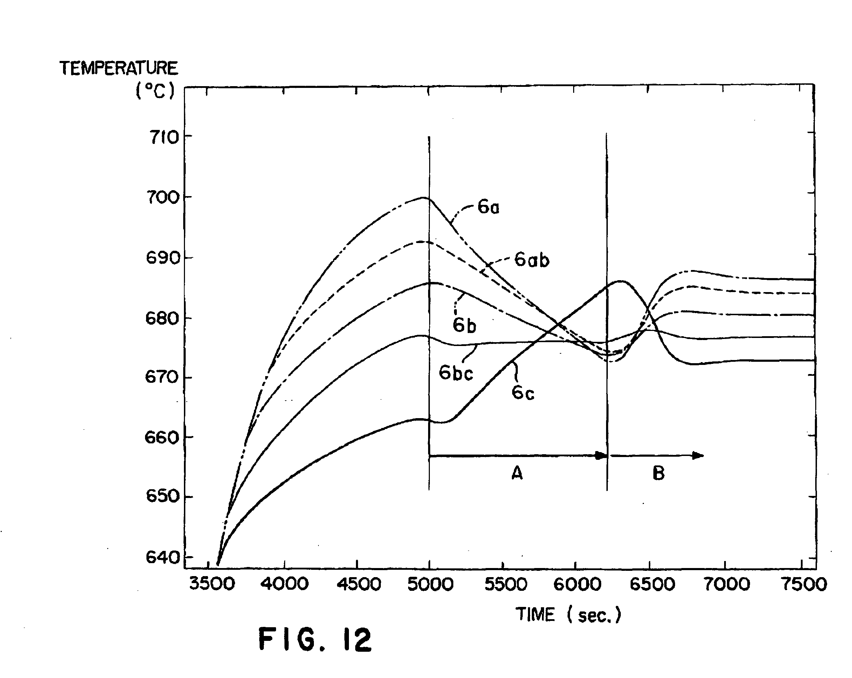

FIG. 12 shows the relationship between time and temperature in each of the zones when a silicon oxide film is deposited on the surface of a wafer w using TEOS as a process gases.

In the method shown in FIG. 12, the reaction tube 1 is divided into five zones 6a, 6ab, 6b, 6bc and 6c from top, and different temperature controls are performed for the zones 6a, 6ab, 6b, 6bc and 6c. Reference numerals 6a through 6c are shown in FIG. 12 for convenience.

The first process temperatures and second process temperatures in the zones 6a, 6ab, 6b, 6bc and 6c are 699°C and 672 °C (zone 6a), 692 °C and 674°C (zone 6ab), 685°C and 673°C (zone 6b), 675°C and 675°C (zone 6bc), and 662°C and 685°C (zone 6c), so that the first process temperatures and second process temperatures are different among the respective zones 6a through 6c.

As shown in FIG. 12, in all of the zones 6a, 6ab, 6b, 6bc and 6c, the temperature is first raised to the first process temperature (temperature rising step), and thereafter, the temperature transition step or temperature changing step (A) in which TEOS is fed is carried out.

At the temperature transition step (A), the temperature in the zone 6c is raised from the first process temperature to the second process temperature, the temperature in the zone 6bc is isothermally held from the first process temperature to the second process temperature, and the temperatures in the zones 6a, 6ab and 6b are lowered from the first process temperature to the second process temperature.

In this case, in the respective zones 6a, 6ab, 6b, 6bc and 6c, the temperature may be subsequently changed from the second process temperature to the first process temperature (additional temperature transition step or additional temperature transition step), and thereafter, the temperature may be changed from the first process temperature to the second process temperature (additional temperature transition step).

Thereafter, a temperature holding step (B) is carried out in each of the zones 6a, 6ab, 6b, 6bc and 6c.

In the lower zone 6c, the thickness of the deposited film on the central portion of the wafer would tend to be larger than that on the peripheral edge portion of the wafer if the temperature control is not carried out, so that the temperature is raised at the temperature rising step (A) unlike the temperature controls in other zones 6a, 6ab, 6b and 6bc.

In the zone 6bc arranged immediately above the lower zone 6c, the difference between the thickness of the film deposited on the peripheral edge portion of the wafer and the thickness of the film deposited on the central portion of the wafer is very small when both the portions have a constant temperature, so that the temperature is isothermally held at the temperature transition step (A).

In the above described preferred embodiment, the temperature rising step and temperature lowering step other than isothermally holding step of the temperature transition step constitute a temperature changing step, and the temperature rising step and temperature lowering step other than isothermally holding step of the additional temperature transition step constitute an additional temperature changing step.

By thus carrying out different temperature controls in the respective zones 6a, 6ab, 6b, 6bc and 6c, it is possible to achieve the uniformity of the silicon oxide films deposited on the surface of the wafer W in the respective zones 6a, 6ab, 6b, 6bc and 6c, in addition to the uniformity of the silicon oxide films on the respective wafers.

## Claims

1. A substrate processing method for processing a substrate by arranging the substrate in each of a plurality of zones in a reaction vessel and feeding a process gas into the reaction vessel, said substrate processing method comprising:
a temperature rising step of heating each of said zones in said reaction vessel by a heating unit to raise the temperature in each of said zones to a first process temperature for a corresponding one of said zones; and
a temperature transition step of transferring the temperature in each of said zones in said reaction vessel from said first process temperature for the corresponding one of said zones to a second process temperature for the corresponding one of said zones,
wherein a process gas is fed into said reaction vessel in said temperature transition step to process said substrate.

2. The substrate processing method according to claim 1, wherein said first process temperature for the corresponding one of said zones is different from that for another one of said zones.

3. The substrate processing method according to claim 1, wherein
said second process temperature for the corresponding one of said zones is different from that for another one of said zone.

4. The substrate processing method according to claim 1, wherein
the temperature in each of said zones is lowered, raised or held from said first process temperature to said second process temperature in said temperature transition step.

5. The substrate processing method according to claim 1, wherein
the temperature in each of said zones is lowered or raised from said first process temperature to said second process temperature at said temperature transition step.

6. The substrate processing method according to claim 1, wherein
each of said zones in said reaction vessel is heated in said temperature rising step by a heating part of the heating unit which is provided outside the corresponding one of said zones.

7. The substrate processing method according to claim 1, wherein
the feeding of said process gas into said reaction vessel is stopped at said temperature rising step.

8. The substrate processing method according to claim 1, wherein
each of said zones is heated to said first process temperature of 770 °C in said temperature rising step, and the temperature in each of said zones is lowered from said first process temperature of 770°C to said second process temperature of 750 °C in said temperature transition step.

9. The substrate processing method according to claim 6, wherein
the heating of one of said zones by said heating part corresponding to said one of said zones is suppressed to lower the temperature in said one of said zones in said temperature transition step.

10. The substrate processing method according to claim 1, wherein
a deposition gas is fed from a gas feed tube provided in the peripheral portion of said reaction vessel, in said temperature transition step.

11. The substrate processing method according to claim 1,
further comprising an additional temperature transition step for changing the temperature in each of said zones from said second process temperature to said first process temperature.

12. The substrate processing method according to claim 7, wherein
said temperature transition step and said additional temperature transition step are repeatedly carried out.

13. A substrate processing method for processing a substrate by arranging the substrate in each of a plurality of zones in a reaction vessel and feeding a process gas into the reaction vessel, said substrate processing method comprising:
a temperature rising step of heating each of said zones in said reaction vessel by a heating unit to raise the temperature in each of said zones to a first process temperature for a corresponding one of said zones; and
a temperature changing step of changing the temperature in each of said zones in said reaction vessel from said first process temperature for the corresponding one of said zones to a second process temperature for the corresponding one of said zones,
wherein a process gas is fed into said reaction vessel in said temperature changing step to process said substrate.

14. The substrate processing method according to claim 13, wherein
said first process temperature for the corresponding one of said zones is different from that for another one of said zones.

15. The substrate processing method according to claim 14, wherein
said second process temperature for the corresponding one of said zones is different from that for another one of said zone.

16. The substrate processing method according to claim 13, wherein
the temperature in at least one of said zones is lowered from said first process temperature to said second process temperature in said temperature changing step.

17. The substrate processing method according to claim 13, wherein
the temperature in at least one of said zones is raised from said first process temperature to said second process temperature in said temperature changing step.

18. The substrate processing method according to claim 13, wherein
each of said zones in said reaction vessel is heated in said temperature rising step by a heating part of the heating unit which is provided outside the corresponding one of said zones.

19. The substrate processing method according to claim 13, wherein
the feeding of said process gas into said reaction vessel is stopped in said temperature rising step.

20. The substrate processing method according to claim 18, wherein
the heating of one of said zones by said heating part corresponding to said one of said zones is suppressed to lower the temperature in said one of said zones in said temperature changing step.
